(19) Europäisches Patentamt
European Patent Office
Office européen des brevets

(11) **EP 2 033 310 B1**

(12) **EUROPÄISCHE PATENTSCHRIFT**

(45) Veröffentlichungstag und Bekanntmachung des Hinweises auf die Patenterteilung:
**02.03.2011 Patentblatt 2011/09**

(21) Anmeldenummer: **07720120.0**

(22) Anmeldetag: **04.05.2007**

(51) Int Cl.:
*H03J 3/04* (2006.01)     *H03B 5/04* (2006.01)
*H03K 17/95* (2006.01)     *H03L 1/02* (2006.01)

(86) Internationale Anmeldenummer:
**PCT/CH2007/000223**

(87) Internationale Veröffentlichungsnummer:
**WO 2008/000100 (03.01.2008 Gazette 2008/01)**

(54) **TEMPERATURSTABILISIERTER SCHWINGKREIS FÜR INDUKTIVE SENSOREN**

THERMALLY STABLE RESONANT CIRCUIT FOR INDUCTIVE SENSORS

CIRCUIT OSCILLANT STABILISÉ EN TEMPÉRATURE POUR CAPTEURS INDUCTIFS

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **27.06.2006 CH 10342006**

(43) Veröffentlichungstag der Anmeldung:
**11.03.2009 Patentblatt 2009/11**

(73) Patentinhaber: **Baumer Electric AG**
**8500 Frauenfeld (CH)**

(72) Erfinder:
• **BRÄNDLE, Daniel**
**CH-8500 Frauenfeld (CH)**
• **GUGGENBÜHL, Walter**
**CH-8712 Stäfa (CH)**

(74) Vertreter: **Gachnang, Hans Rudolf et al**
**Patentanwalt H.R. Gachnang**
**Badstrasse 5**
**Postfach**
**8501 Frauenfeld (CH)**

(56) Entgegenhaltungen:
EP-A1- 0 813 306     DE-A1- 1 589 826
FR-A1- 2 657 427     JP-A- 5 063 559

**Beschreibung**

Gegenstand der Erfindung ist ein temperaturstabilisierter LC-Parallelschwingkreis gemäss dem Oberbegriff des Patentanspruchs 1 sowie ein induktiver Näherungssensor gemäss dem Oberbegriff des Patentanspruchs 5 und ein Verfahren zum Neutralisieren des Leitungswiderstandes gemäss dem Oberbegriff des Patentanspruchs 6.

Induktive Näherungssensoren basieren auf der Dämpfung eines in einer Oszillatorschaltung eingesetzten Schwingungskreises durch die in einer metallischen Messplatte (Target) induzierten Wirbelströme als Mass für die Distanz dieses sog. Targets von der als Messspule eingesetzten Induktivität des Schwingungskreises.

Auf diesem Prinzip operierende Oszillatoren können in verschiedener Form (Schwingamplitude, Einsatz oder Abreissen der Schwingung) zur Gewinnung von Information über die Targetdistanz eingesetzt werden. Dabei wird zwischen Distanzschaltern und sog. analogen Distanzsensoren, die eine distanzabhängige Ausgangsspannung liefern, unterschieden.

Ein Problem handelsüblicher induktiver Distanzsensoren ist der relativ kleine messbare Targetabstand. Einer Erhöhung steht bei den einfacheren Sensoren die Temperaturabhängigkeit der Eigenverluste der Messspule entgegen, wobei die sogenannten Leitungs- oder Kupferverluste bzw. die Änderung des ohmschen Wicklungswiderstandes den dominanten Teil liefern. Zahlreiche in der Patentliteratur publizierte Verbesserungen betreffen daher die Elimination dieses dominanten Dämpfungsanteils. Aus der DE-A1-1589826 ist ein Verfahren zur Kompensation des Einflusses des Wicklungswiderstandes RS der Schwingspule bekannt, bei dem eine Kompensationsspule mit zwei (bifilar) oder mehreren Wicklungen eingesetzt wird. Ein Nachteil dieser Methode ist der gegenüber Eindrahtspulen kostspielige Montageaufwand.

Das Abstract der JP-A-5063559 (Sharp Corp) offenbart eine Regelung der Verstärkung des Spulensignals in Abhängigkeit der (temperaturabhängigen) Spulengüte. Diese wird anhand eines DC-Signals ermittelt, mit dem die Spule periodisch beaufschlagt wird.

Aus der EP-B1-0813306 ist ein weiteres Verfahren zur Kompensation des Einflusses des Wicklungswiderstandes RS der Schwingspule bekannt, bei welchem parallel zur Spule bzw. zum Oszillator ein virtueller negativer Widerstand vorgesehen ist. Somit wirkt sich diese Kompensation allerdings auch auf das Dämpfungsverhalten des Oszillators durch ein zu erfassendes Objekt bzw. Target aus.

Der vorliegenden Erfindung liegt die Aufgabe zugrunde, eine gattungsgemässe Sensorspule, bzw. den zugehörigen Oszillator zu schaffen, welcher ohne die oben genannten Nachteile eine wirksame Kompensation der Auswirkung der Temperaturabhängigkeit des Widerstandes RS der Schwingkreisspule auf die resultierende Abhängigkeit des Verhaltens des Schwingkreises von der Targetdistanz aufweist. Damit soll eine einfache Herstellung induktiver Näherungssensoren mit grossem Distanzbereich möglich werden.

Diese Aufgabe wird gelöst durch einen temperaturstabilisierten LC-Schwingkreis gemäss den Merkmalen des Patentanspruchs 1 sowie einen induktiven Näherungssensor gemäss den Merkmalen des Patentanspruchs 5 und durch ein Verfahren zum Neutralisieren des Leitungswiderstandes gemäss den Merkmalen des Patentanspruchs 6.

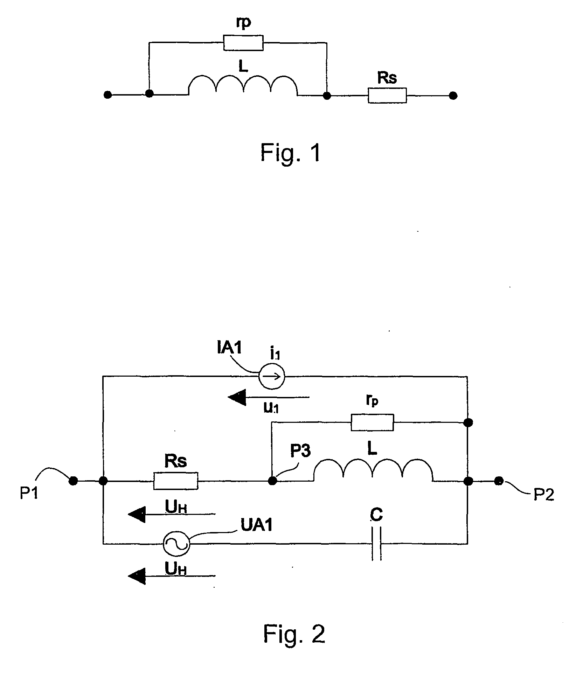

Durch gezielte Reduktion bzw. Elimination des Anteils des ohmschen Spulenwiderstandes RS und Belassung des Dämpfungswiderstandes rP bei LC-Schwingkreisen in Näherungsschaltern oder analogen Induktivsensoren (mit einer von der Targetdistanz abhängigen Ausgangsspannung) kann deren Reichweite bzw. Erfassungsbereich deutlich erhöht werden. Der Erfindung liegt die Idee zugrunde, die Schwingkapazität C nicht parallel zur Schwingspule L anzuordnen, sondern eine ihrer Klemmen mit einer Spannungsquelle uH zu verbinden, deren Spannung derjenigen des virtuellen (in der Spule nicht zugänglichen) Knotens zwischen L und RS im Spulenmodell (Fig.1) entspricht.

Anhand einiger Figuren wird die Erfindung im Folgenden näher beschrieben. Dabei zeigen

Figur 1    eine Ersatzschaltung einer verlustbehafteten Spule,

Figur 2    eine virtuelle Modifikation eines LC- Parallelschwingkreises zur Elimination Einflusses des Kupferwiderstands RS der Spule auf die Dämpfung,

Figur 3    ein Prinzipschaltbild einer Anordnung zur Elimination des Kupferwiderstandes RS der Spule mittels einer steuer- oder regelbaren Hilfsspannungsquelle,

Figur 4    eine dem Prinzipschaltbild aus Figur 3 entsprechende Schaltungsanordnung mit einem regelbaren Verstärker,

Figur 5    ein Rechenschema zur Bildung einer Hilfsspannung uH mittels Quotientenbildung und multiplizierendem D/A Konverter,

Figur 6    eine Schaltung zur Bildung des digitalen Wertes der Verstärkung vK,

Figur 7    ein Beispiel eines multiplizierenden D/A Konverters mit teilweise fixen Bits,

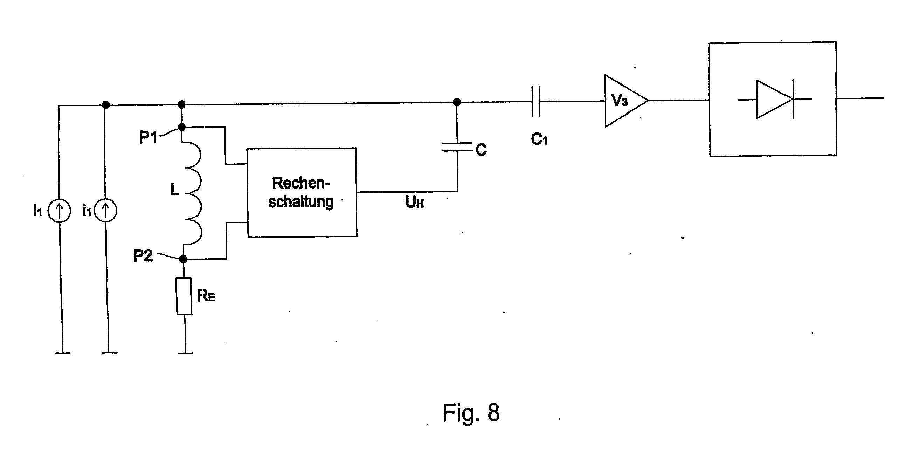

Figur 8    eine Prinzipdarstellung der Anordnung einer entdämpften Spule in einem analogen Distanzsensor.

Anhand des in Figur 1 dargestellten Spulenmodells werden im Folgenden die Verluste der Schwingspule charakterisiert. Die Verluste werden formal durch zwei konzentrierte Widerstände RS und rP verursacht. Dabei entspricht der Seriewiderstand RS dem ohmschen Leitungswiderstand der Spule L bzw. den Kupferverlusten, während rP diverse, nur bei der Schwingfrequenz in Erscheinung tretende Verluste der Schwingspule L, des Magnetkerns und des Gehäuses nachbildet. Insbesondere sind auch die distanzabhängigen sog. Targetverluste Teil des Dämpfungswiderstands rP.

In Figur 2 ist ein modifizierter LC- Schwingkreis dargestellt, bei dem seriell zum Kondensator C eine Hilfsspannungsquelle UA1 angeordnet ist. Diese serielle Anordnung ist parallel zur Spule L geschaltet. Zusätzlich ist in Figur 2 eine Stromquelle IA1 zum Einspeisen eines Schwingstroms i1 in den modifizierten Schwingkreis dargestellt. Die Hilfsspannungsquelle UA1 ist so ausgebildet, dass ihre Spannung UH derjenigen des virtuellen (in der Spule nicht zugänglichen) Knotens P3 zwischen L und $R_S$ entspricht.

Der mittels der Stromquelle IA1 in den veränderten LC-Schwingkreis eingespeiste Schwingstrom i1 sieht zwischen den Klemmen P1 und P2 einen Resonanzkreis, der praktisch lediglich durch rP bedämpft ist. Der Spulenwiderstand (fortan auch Kupferwiderstand oder Leitungswiderstand genannt) liegt nun quasi in Serie zu diesem Parallel LC Kreis. Bei der Resonanzfrequenz addiert er sich zu rP und ist wegen RS << rP damit praktisch ohne Einfluss auf die Dämpfung. Gl.(1) für die Impedanz u1/i1 bestätigt diese Eigenschaft.

$$\frac{u1}{i1} = Zp \approx \frac{s \bullet L}{s^2 LC + \frac{sL}{rp} + 1} \qquad s{=}j\omega \qquad\qquad (1)$$

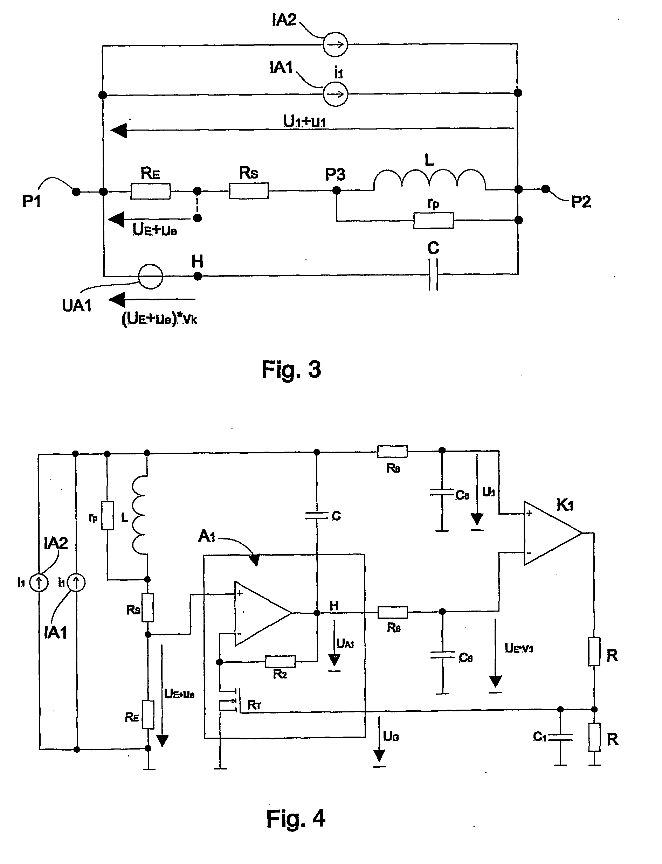

Den Ausgangspunkt für die Generierung dieser oben definierten Quellenspannung uH bildet das Spulen-Ersatzmodell aus Figur 1. Erfindungsgemäss wird zur Erzeugung einer der oben erwähnten virtuellen Knotenspannung entsprechenden Spannung uH ein Messwiderstand RE (Re<<rp) in Serie zur Schwingspule L geschaltet und die vom Schwingstrom i1 über diesem Widerstand RE erzeugte Wechselspannung ue gemessen (Figur 3). Gelingt es nun, diese Spannung mit dem Faktor vK =(RS+RE)/RE zu verstärken, so entsteht die Spannung uA1,

$$uA1 \;=\; ue{*}vK \;=\; ue{*}(RS{+}RE)/RE \qquad\qquad (2)$$

welche die Spannung uH des virtuellen Knotens zwischen L und RS im Spulenmodell der Figur 1 nachbildet. In Analogie zu Figur 2 werden bei der Rückführung der Schwingkapazität C auf diese Hilfsspannung uH die Dämpfungsbeiträge der Widerstände RS und RE des so entstehenden Parallelschwingkreises eliminiert.

Figur 3 zeigt ein erfindungsgemäss dazu geeignetes Prinzipschema, in dem die Spannung über RE mit dem Faktor vK verstärkt wird. Zur Messung der dazu notwendigen Verstärkung vK wird über die Serieschaltung "Spule + RE" ein Gleichstrom I1 von einer Hilfsstromquelle IA2 geschickt (Figur 3). Über der Strecke "Spule + RE" entsteht dabei die Gleichspannung U1 = I1 * (RS+RE) und über dem Widerstand RE die Spannung UE = I1 * RE. Damit kann vK aus den beiden Gleichspannungen gemäss

$$vK \;=\; U1/UE \qquad\qquad (3)$$

berechnet und die Generation von uH gemäss Gleichung (1) schaltungsmässig implementiert werden. Im Betrieb als Sensorspule eines Parallelschwingkreises fliesst zudem einen Wechselstrom konstanter Amplitude i1 und der Frequenz f über den so erweiterten Schwingkreis und es entsteht eine Schwingspannung u1 die einem lediglich durch rP bedämpften Kreis entspricht. Da rP den distanzabhängigen Dämpfungsanteil durch das Target enthält, ist damit das Ziel der RS-Unabhängigkeit dieser Messung erreicht. Insbesondere kann die Frequenz des eingespeisten wechselstroms i1 der Resonanzfrequenz des Schwingkreises entsprechen, nämlich dann, wenn der Parallelschwingkreis als frequenzbestimmendes Glied des zugrundeliegenden Oszillators benutzt wird.

Eine erste erfindungsgemässe Schaltung verwendet zur Erzeugung von uH gemäss Gl.(2) eine nichtinvertierende Operationsverstärkerschaltung deren Verstärkung v1 mittels einer Spannung UG steuerbar ist. Eine Ausführungsform dieses Verstärkerblocks A1 ist in der Fig.4 dargestellt, wobei im Gegenkopplungspfad des Operationsverstärkers ein MOS Transistor, der im ohmschen Bereich betrieben wird, eingesetzt ist. Sein Widerstand RT ist mittels der Gate-Source-Spannung UG des Transistors steuerbar. Anstelle des MOS Transistors sind auch andere steuerbare Widerstände (z.B. digitale Potentiometer) einsetzbar. Die Verstärkung des Blocks A1 wird

$$v1 = (RT+R2)/RT \qquad\qquad (3)$$

und ist somit über UG steuerbar. Erfindungsgemäss wird nun die für die Elimination des Einflusses von RS erforderliche Verstärkung vK gemäss dem oben beschriebenen Verfahren mit Hilfe eines überlagerten Gleichstroms I1 gemessen und mittels Steuerung von RT(UG) dieselbe Verstärkung im Verstärkerblock A1 eingestellt. Dabei wird die Messung der Verstärkung vK aus den Gleichspannungen U1 und UE (Gleichung 3) besonders einfach, weil UE*v1 als Gleichspannungsanteil am Ausgang des Verstärkerblocks A1 erscheint und dort mit der Gleichspannung U1 über der Spule L verglichen werden kann. Die Differenz der beiden Spannungen steuert RT über den Vergleicher K1 so, dass vK = v1 gilt. Dabei müssen die Schwingspannungsanteile vor den Vergleichereingängen durch Tiefpässe (R-C Glieder) entfernt werden. Da der Verstärkerblock A1 nun neben der Gleichspannung UE auch den über RE stehenden Schwingspannungsanteil ue mit demselben Faktor v1 = vK verstärkt, erzeugt er damit am Ausgang des Verstärkers die gewünschte Hilfsspannung uH. An den Verstärkerblock A1 und den Vergleicher K1 werden hohe Ansprüche bezüglich Gleichspannungsoffset gestellt. Bekannte Verfahren zur Realisierung kleiner Offsets arbeiten beispielsweise nach dem Chopper- oder Autozero-Prinzip. Die dazu notwendigen Erweiterungen der Schaltung sind in Figur 4 nicht dargestellt. Anstelle eines Gleichstroms kann auch ein Wechselstrom mit Frequenz << Schwingfrequenz verwendet werden.

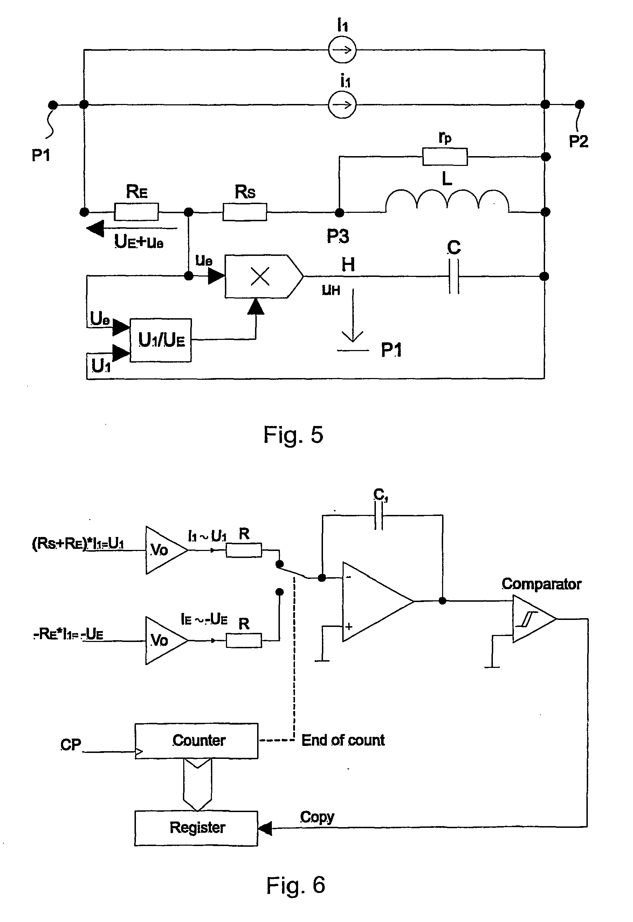

Die Figuren 5 bis 7 zeigen alternative rechen- und/oder schaltungstechnische Lösungen für die Implementation der Gleichungen (1) und (2). Das Rechenschema ist in Figur 5 dargestellt. Die Quotientenbildung gemäss Gleichung (2) kann beispielsweise mit Hilfe des sog. Doppelrampen-Prinzips erfolgen, welches z.B. mit einer Schaltung gemäss Figur 6 durchführbar ist. In den Rückkopplungspfad eines invertierenden Operationsverstärkers wird dazu eine Integrationskapazität C1 geschaltet die während einer fixen Zeit tRef mit einem Strom I1 proportional U1 aufgeladen und nachfolgend mit einem Strom IE proportional -UE entladen wird. Die digitale zeitmessung erfolgt in klassischer Weise mit Hilfe eines Zählers. tRef wird durch den Modulus und die Zählfrequenz bestimmt. Die Umschaltung auf die Entladung von C1 erfolgt nach dem ersten Überlauf dieses Zählers.

Nach Ende der Entladung steht im entsprechenden Zähler der digitale Wert des Quotienten.

$$vK = te/tRef = (RS+RE)/RE \qquad\qquad (4)$$

Die Gleichspannungen U1 und UE werden zur Erhöhung der Präzision vor der Quotientenbildung durch den Doppelrampenkonverter um den Faktor v0 verstärkt; die Gleichspannungsoffsets der betreffenden Verstärker sind zu kompensieren.

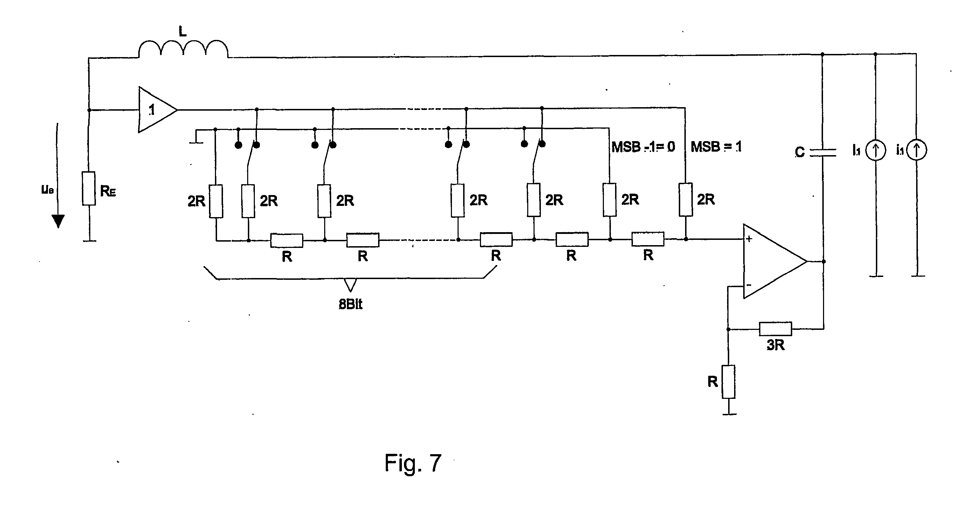

Alternativ ist ein Digitalwert der Verstärkung vK mittels A/D-Wandler mit Referenzspannung UE und Signaleingang U1 erzeugbar. Gemäss G1. (2) gilt vK > 1. Die Multiplikation gemäss Gleichung 1 kann mittels eines multiplizierenden D/A-Konverters mit ue als Analogeingang und dem digitalen Wert von vK als Digitaleingang durchgeführt werden. Durch die Wahl RE > RSmax bleibt vK in den Grenzen 1 < vK < 1.5, was den Entwurf des multiplizierenden D/A-Konverters erleichtert. (MSB = 1, MSB-1 =0). Figur 7 zeigt als Beispiel eine Ausführungsform des Konverters, wobei das sog. Ladder-Netzwerk mit fixen Werten des MSB und des MSB-1 realisiert ist.

Andere Ausführungsformen der Rechenschaltungen aus Figur 3 sind ohne weiteres möglich. So kann die Multiplikation / Division mittels der bekannten Anordnung mit einem Log-Antilog Multiplier/Divider erfolgen (siehe z.B. C. Toumazou et.al. "Analogue IC Design, the current mode approach" 1993, ISBN 086341 215 7, page 68).

Die Verfügbarkeit des digitalen Wertes der Verstärkung vK in digitaler Form ermöglicht Flexiblität beim Einsatz eines zusätzlichen Prozessorchips. Dabei kann durch gezielte Veränderung des Werts vK auf Grund einer Temperaturmessung eine Korrektur des verbleibenden Temperaturgangs der Spulenverluste als Folge der Temperaturabhängigkeit von rP und damit eine zusätzliche Erweiterung des Messbereichs erreicht werden.

Der gemäss Figur 3 verbesserte Parallelschwingkreis kann nun in bekannter Weise in einem induktiven Distanzmesser eingesetzt werden, indem die Abhängigkeit von rP von der Targetdistanz ausgewertet wird. Dazu wird ein Wechselstrom i1 über den Schwingungskreis geschickt und die resultierende Wechselspannung über dem Schwingungskreis gemessen. Bei ferromagnetischen Targetmaterialien ist die Frequenz von i1 gleich der Resonanzfrequenz. Alternativ kann bei Buntmetalltargets i1 mit einer gegenüber der Resonanzfrequenz leicht verschobenen Frequenz eingespeist werden. Auch in diesem Fall nutzt man die erhöhte Temperaturstabilität des erfindungsgemäss verbesserten LC-Kreises aus.

Die Auswertung der Schwingspannung über dem LC-Kreis zur Messung der Targetdistanz erfolgt in bekannter Weise. Im Falle eines analogen Distanzmessers wird die Schwingspannung gleichgerichtet und am Ausgang als distanzabhängige Gleichspannung zur Verfügung gestellt. Im Fall eins Distanzschalters wird die Amplitude der Schwingspannung mit einer von der Distanz abhängigen Gleichspannung verglichen und mit dem Resultat ein Ausgangsschalter betätigt.

**Patentansprüche**

1.  Temperaturstabilisierter LC-Parallelschwingkreis umfassend eine Spule (L) mit einem temperaturabhängigen Widerstand (RS) und einen Kondensator (C) sowie eine Stromquelle (IA1) zum Generieren eines Schwingstroms (i1), **dadurch gekennzeichnet, dass** seriell zur Spule (L) ein Messwiderstand (RE) geschaltet ist, dass eine Hilfsspannungsquelle (UA1) in Serie zum Kondensator (C) angeordnet ist, dass diese Serieschaltung aus Kondensator (C) und Hilfsspannungsquelle (UA1) parallel zur Serieschaltung von Spule (L) und Messwiderstand (RE) angeordnet ist, dass die Hilfsspannungsquelle (UA1) mit einer Auswertevorrichtung zum Auswerten der Spannung über dem Messwiderstand (RE) in Wirkverbindung steht und zum Erzeugen einer Hilfsspannung (UH) für die Eliminierung von Dämpfungsbeiträgen der Widerstände (RS) und (RE) ausgebildet ist.

2.  Schwingkreis nach Anspruch 1, **dadurch gekennzeichnet, dass** eine Hilfsstromquelle (IA2) zum Erzeugen eines Gleichstroms oder eines im Vergleich zum Schwingstrom (i1) niederfrequenten Wechselstroms durch den Messwiderstand (RE) und die seriell dazu geschaltete Spule (L) vorgesehen ist.

3.  Schwingkreis nach Anspruch 2 **dadurch gekennzeichnet, dass** die Auswertevorrichtung für die Messung der Gleichspannungen bzw. der niederfrequenten Wechselspannungen (U1 und UE) passive Tiefpässe gefolgt von offsetkompensierten Verstärkern umfasst.

4.  Schwingkreis nach einem der Ansprüche 1 bis 3, **dadurch gekennzeichnet, dass** die Hilfsspannungsquelle (UA1) einen Verstärker mit steuerbarer oder regelbarer Verstärkung umfasst, wobei der Eingang des Verstärkers wirkungsmässig mit dem Messwiderstand (RE) verbunden ist, und wobei die Verstärkung in Abhängigkeit der Spannung über der Serieschaltung aus Spule (L) und Messwiderstand (RE) regelbar ist.

5.  Induktiver Näherungssensor umfassend einen Oszillator mit einem LC-Parallelschwingkreis gemäss einem der Ansprüche 1 bis 4, **dadurch gekennzeichnet, dass** eine Wandlerstufe zum Erzeugen eines analogen oder digitalen Ausgangssignals in Abhängigkeit der Schwingungsamplitude des Oszillators vorgesehen ist.

6.  Verfahren zum Neutralisieren des Leitungswiderstandes (RS) bei einem LC-Parallelschwingkreis gemäss einem der Ansprüche 1 bis 4 oder bei einem induktiven Näherungssensor gemäss Anspruch 5, **dadurch gekennzeichnet, dass** die Hilfsspannungsquelle (UA1) eine Wechselspannung (uH) erzeugt, welche der Spannung entspricht, die der Schwingstrom (i1) über der Serieschaltung aus Spulenwiderstand (RS) und Messwiderstand (RE) erzeugt.

7.  Verfahren nach Anspruch 6, **dadurch gekennzeichnet, dass** zusätzlich oder alternativ zum Schwingstrom (i1) ein Hilfsstrom (I1) durch den Messwiderstand (RE) und den seriell dazu geschalteten Spulenwiderstand (RS) erzeugt wird, wobei dieser Hilfsstrom (I1) ein Gleichstrom oder ein im Vergleich zum Schwingstrom (i1) niederfrequenter Wechselstrom sein kann, und dass die durch den Hilfsstrom (I1) über dem Messwiderstand (RE) und über der Serieschaltung aus Messwiderstand (RE) und Spule erzeugten Spannungen (U1 bzw. UE) gemessen werden.

8.  Verfahren nach Anspruch 7, **dadurch gekennzeichnet, dass** in Abhängigkeit der gemessenen Spannungen (U1, UE) ein Verstärkungsfaktor (vK) ermittelt wird, der dem Quotienten (U1/UE) der gemessenen Spannungen entspricht, und dass durch Verstärkung des am Messwiderstand (RE) gemessenen Schwingspannungsanteils (ue) mit diesem Verstärkungsfaktor (vK) eine Hilfsspannung (uH) derart erzeugt wird, dass im Falle der Anregung des Schwingkreises durch die Stromquelle (IA1) die Verluste am Leitungswiderstand (RS) und am Messwiderstand (RE) neutralisiert werden, und dass **dadurch** der Gütewert Q des Schwingkreises erhöht und bezüglich Temperatureinflüssen stabilisiert wird.

9.  Verfahren nach Anspruch 8, **dadurch gekennzeichnet, dass** die verstärkten Spannungen (U1, UE) mittels eines A/D-Konverters digitalisiert wird und der Quotient (U1/UE) digital berechnet wird.

10. Verfahren nach einem der Ansprüche 8 oder 9, **dadurch gekennzeichnet, dass** der digitale Wert des Quotienten (U1/UE) mit Hilfe eines A/D-Doppelrampenkonverters (dual-slope converter) gebildet wird, wobei eine Integrationskapazität (C1) mit einem Strom (I1) proportional zur Spannung (U1) während einer fixen Referenzzeit $t_{Ref}$ geladen wird und anschliessend die Entladezeit (tE) der Kapazität (C1) mit einem zur Spannung (UE) proportionalen Strom gemessen wird.

**11.** Verfahren nach Anspruch 8, **dadurch gekennzeichnet, dass** die Hilfsspannung (uH) mittels eines multiplizierenden D/A-Konverters gebildet wird.

**Claims**

**1.** A temperature-stabilised, LC-parallel resonant circuit comprising a coil (L) with a temperature-dependent resistance (RS), and a capacitor (C) as well as a current source (IA1) for generating an oscillating current (11), **characterised in that** a measurement resistance (RE) is connected in series with the coil (L), that an auxiliary voltage source (UA1) is arranged in series with the capacitor (C), that this series connection of the capacitor (C) and the auxiliary voltage source (UA1) is arranged parallel to the series connection of the coil (L) and measurement resistance (RE), that the auxiliary voltage source (UA1) is in active connection with an evaluation device for evaluating the voltage across the measurement resistance (RE) and is designed for producing an auxiliary voltage (UH) for the elimination of damping components of the resistances (RS) and (RE).

**2.** A resonant circuit according to claim 1, **characterised in that** an auxiliary current source (IA2) is provided for producing a direct current or an alternating current which is low frequency compared to the oscillating current, through the measurement resistance (RE) and the coil (L) which is connected in series to this.

**3.** A resonant circuit according to claim 2, **characterised in that** the evaluation device for the measurement of the direct voltages or the low-frequency alternating voltages (U1 and UE) comprises passive low-passes followed by offset-compensated amplifiers.

**4.** A resonant circuit according to one of the claims 1 to 3, **characterised in that** the auxiliary voltage source (UA1) comprises an amplifier with an amplification which may be controlled with or without a closed loop, wherein the input of the amplifier is actively connected to the measurement resistance (RE), and wherein the amplification may be controlled with a closed loop in dependence on the voltage across the series connection of the coil (L) and the measurement resistance (RE).

**5.** An inductive proximity sensor comprising an oscillator with a LC-parallel resonant circuit according to one of the claims 1 to 4, **characterised in that** a transducer stage is provided for producing an analog or digital output signal in dependence on the oscillation amplitude of the oscillator.

**6.** A method for the neutralisation of the line resistance (RS) with an LC-parallel resonant circuit according to one of the claims 1 to 4 or with an inductive proximity sensor according to claim 5, **characterised in that** the auxiliary voltage source (UA1) produces an alternating voltage (uH) which corresponds to the voltage which the oscillating current (i1) produces across the series connection of the coil resistance (RS) and the measurement resistance (RE).

**7.** A method according to claim 6, **characterised in that** additionally or alternatively to the oscillating current (i1), an auxiliary current (I1) is produced by the measurement resistance (RE) and the coil resistance (RS) which is connected in series to this, wherein this auxiliary current (I1) may be a direct current or an alternating current which is low-frequency compared to the oscillating current, and that the voltages (U1 and UE respectively) produced by the auxiliary current (I1) across the measurement resistance (RE) and across the series connection of the measurement resistance (RE) and coil, are measured.

**8.** A method according to claim 7, **characterised in that** an amplification factor (vK) is determined in dependence on the measured voltages (U1, UE), and this factor corresponds to the quotient (U1/UE) of the measured voltages, and that by way of amplification of the oscillating voltage component (ue) measured at the measurement resistance (RE), by this amplification factor (vK), an auxiliary voltage (uH) is produced in a manner such that in the case of an excitation of the resonant circuit by the current source (IA1), the losses at the line resistance (RS) and at the measurement resonance (RE) are neutralised, and that by way of this the quality characteristics Q of the resonant circuit are increased and is stabilised with respect to temperature influences.

**9.** A method according to claim 8, **characterised in that** the amplified voltages (U1, UE) are digitalised by way of a A/D transducer, and the quotient (U1/UE) is computed digitally.

**10.** A method according to one of the claims 8 or 9, **characterised in that** the digital value of the quotient (U1/UE) is formed with the help of a A/D dual slope converter, wherein an integration capacitance (C1) is charged with a current (I1) proportionally to the voltage (U1) during a fixed reference time $t_{ref}$ and subsequently the discharge time (tE) of the capacitance (C1) is measured with a current proportional to the voltage (UE).

11. A method according to claim 8, **characterised in that** the auxiliary voltage (uH) is formed by way of a multiplying D/A converter.

**Revendications**

1. Circuit oscillant parallèle LC stabilisé en température, comportant une bobine (L) munie d'une résistance dépendante de la température (RS) et d'un condensateur (C) ainsi que d'une source de courant (IA1) pour la génération d'un courant d'oscillation (i1), **caractérisé en ce qu'**une résistance de mesure (RE) est branchée en série à la bobine (L), **en ce qu'**une source de tension auxiliaire (UA1) est agencée en série par rapport au condensateur (C), **en ce que** ce branchement en série depuis le condensateur (C) et depuis la source de tension auxiliaire (UA1) est agencé en parallèle par rapport au branchement en série de la bobine (L) et de la résistance de mesure (RE), **en ce que** la source de tension auxiliaire (UA1) se trouve en liaison efficace avec un dispositif d'évaluation pour évaluer la tension sur la résistance de mesure (RE) et est réalisée afin de générer une tension auxiliaire (UH) pour l'élimination des contributions d'amortissement des résistances (RS) et (RE).

2. Circuit oscillant selon la revendication 1 **caractérisé en ce qu'**une source de courant auxiliaire (IA2) est prévue pour la génération d'un courant continu ou d'un courant alternatif à basse fréquence (i1) en comparaison au circuit oscillant par l'intermédiaire de la résistance de mesure (RE) et par la bobine (L) qui y est branchée en série.

3. Circuit oscillant selon la revendication 2 **caractérisé en ce que** le dispositif d'évaluation pour la mesure des tensions continues ou des tensions alternatives à basse fréquence (U1 et UE) comporte des passe-bas passifs suivis d'amplificateurs à compensation offset.

4. Circuit oscillant selon l'une des revendications 1 à 3 **caractérisé en ce que** la source de tension auxiliaire (UA1) comporte un amplificateur avec une amplification qui peut être commandée ou régulée, dans lequel l'entrée de l'amplificateur est reliée à la résistance de mesure (RE) du point de vue de l'efficacité, et dans lequel l'amplification peut être régulée en dépendance de la tension par l'intermédiaire du branchement en série depuis la bobine (L) et la résistance de mesure (RE).

5. Capteur de proximité inductif, comportant un oscillateur muni d'un circuit oscillant parallèle LC conformément à l'une des revendications 1 à 4, **caractérisé en ce qu'**un échelon de transducteur est prévu pour la génération d'un signal de sortie analogique ou numérique en dépendance de l'amplitude d'oscillation de l'oscillateur.

6. Procédé pour la neutralisation de la résistance de conducteur (RS) dans un circuit oscillant parallèle LC conformément à l'une des revendications 1 à 4 ou dans un capteur de proximité inductif conformément à la revendication 5, **caractérisé en ce que** la source de tension auxiliaire (UA1) génère une tension alternative (uH), laquelle correspond à la tension qui génère le courant oscillant (i1) par l'intermédiaire du branchement en série depuis la résistance de bobine (RS) et la résistance de mesure (RE).

7. Procédé selon la revendication 6 **caractérisé en ce que**, en supplément ou comme alternative au courant oscillant (i1), un courant auxiliaire (I1) est généré à travers la résistance de mesure (RE) et la résistance de bobine (RS) qui y est branchée, dans lequel ce courant auxiliaire (I1) peut être un courant continu ou un courant alternatif à basse fréquence en comparaison au courant oscillant (i1), et **en ce que** les tensions (U1 ou UE), générées par le courant auxiliaire (I1) par l'intermédiaire de la résistance de mesure (RE) et par l'intermédiaire du branchement en série constitué de la résistance de mesure (RE) et de la bobine, sont mesurées.

8. Procédé selon la revendication 7 **caractérisé en ce que**, en dépendance des tensions mesurées (U1, UE), un facteur d'amplification (vK) est déterminé, lequel correspond au quotient (U1/UE) des tensions mesurées, et **en ce que**, suite à l'amplification de la part de tension oscillante (ue) mesurée sur la résistance de mesure (RE) avec ce facteur d'amplification (vK), une tension auxiliaire (uH) est générée de telle sorte que, dans le cas de l'excitation du circuit oscillant par la source de courant (IA1), les pertes sur la résistance de conducteur (RS) et sur la résistance de mesure (RE) sont neutralisées, et **en ce que** la valeur de qualité Q du circuit oscillant est augmentée de ce fait et est stabilisée en ce qui concerne les influences de la température.

**9.** Procédé selon la revendication 8 **caractérisé en ce que** les tensions amplifiées (U1, UE) sont calculées au moyen d'un convertisseur analogique/numérique et **en ce que** le quotient (U1/UE) est calculé numériquement.

**10.** Procédé selon l'une ou l'autre des revendications 8 et 9, **caractérisé en ce que** la valeur numérique du quotient (U1/UE) est formée à l'aide d'un convertisseur analogique/numérique à double rampe (dual-slope converter), dans lequel une capacité d'intégration (C1) avec un courant (I1) proportionnel à la tension (U1) est chargée pendant un temps de référence fixe $t_{Réf}$ et que pour finir, le temps de décharge (tE) de la capacité (C1) est mesuré avec un courant proportionnel à la tension (UE).

**11.** Procédé selon la revendication 8 **caractérisé en ce que** la tension auxiliaire (uH) est formée au moyen d'un convertisseur analogique/numérique qui multiplie.

Fig. 1

Fig. 2

Fig. 3

Fig. 4

Fig. 5

Fig. 6

Fig. 7

Fig. 8

13

**IN DER BESCHREIBUNG AUFGEFÜHRTE DOKUMENTE**

**In der Beschreibung aufgeführte Patentdokumente**

- DE 1589826 A1
- JP 5063559 A
- EP 0813306 B1